# FASCICULE DE BREVET EUROPEEN

(11) **EP 3 465 739 B1**
(45) Date de publication et mention de la délivrance du brevet: **13.04.2022**
(21) Numéro de dépôt: 17726600.4
(22) Date de dépôt: 23.05.2017
(51) Int. Cl.: H01L 21/033, H01L 21/311, H01L 21/3213, G03F 7/00, B81C 1/00, H01L 21/3115, H01L 21/3215

(54) **PROCÉDÉ DE FORMATION D'UN MOTIF DE GUIDAGE FONCTIONNALISÉ POUR UN PROCÉDÉ DE GRAPHO-ÉPITAXIE**
VERFAHREN ZUR HERSTELLUNG EINES FUNKTIONALISIERTEN FÜHRUNGSMUSTERS FÜR EIN GRAPHOEPITAXIEVERFAHREN
METHOD FOR FORMING A FUNCTIONALISED GUIDE PATTERN FOR A GRAPHOEPITAXY METHOD

(30) Priorité: 27.05.2016 FR 1654790
(43) Date de publication de la demande: 10.04.2019
(73) Titulaire: Commissariat à l'Énergie Atomique et aux Énergies Alternatives, 75015 Paris (FR)
(72) Inventeur: TIRON, Raluca, 38950 Saint-Martin-le Vinoux (FR); POSSEME, Nicolas, 38360 Sassenage (FR); CHEVALIER, Xavier, 38100 Grenoble (FR)
(74) Mandataire: Cabinet Camus Lebkiri
(86) Numéro de dépôt international: PCT/EP2017/062452
(87) Numéro de publication internationale: WO 2017/202859

(56) Documents cités:
- EP-A2- 2 276 690
- WO-A1-2014/102222
- US-A- 4 379 001
- US-A1- 2014 256 145
- LIU CHI-CHUN ET AL: "Fin formation using graphoepitaxy DSA for FinFET device fabrication", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9423, 19 mars 2015 (2015-03-19), pages 94230S-94230S, XP060051595, DOI: 10.1117/12.2086053 ISBN: 978-1-62841-730-2
- CHENG JOY ET AL: "Customization and design of directed self-assembly using hybrid prepatterns", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9423, 19 mars 2015 (2015-03-19), pages 942307-942307, XP060051623, DOI: 10.1117/12.2086973 ISBN: 978-1-62841-730-2
- TIRON R ET AL: "Template affinity role in CH shrink by DSA planarization", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9423, 19 mars 2015 (2015-03-19), pages 942317-942317, XP060051606, DOI: 10.1117/12.2085819 ISBN: 978-1-62841-730-2

## Description

### DOMAINE TECHNIQUE

La présente invention concerne un procédé de formation d'un motif de guidage fonctionnalisé destiné à un procédé de grapho-épitaxie. La présente invention concerne également un procédé de grapho-épitaxie utilisant un motif de guidage fonctionnalisé obtenu par un tel procédé.

### ÉTAT DE LA TECHNIQUE

Le besoin en procédés permettant de réaliser des objets présentant des dimensions toujours plus réduites augmente en permanence, et ce, en raison de la tendance à la miniaturisation des composants électroniques.

Parmi les techniques de lithographie alternatives les plus prometteuses, on peut citer les techniques de lithographie utilisant l'auto-assemblage des copolymères à blocs.

Un copolymère à blocs est un polymère composé de plusieurs blocs de monomères, par exemple de deux blocs de monomères A et B, de natures chimiques différentes, reliés entre eux par une liaison covalente. Lorsque l'on donne suffisamment de mobilité aux chaines, par exemple en chauffant, la chaîne A et la chaîne B ont tendance à se séparer en phase et à se réorganiser pour former des structures parfaitement organisées, comme par exemple un réseau bidimensionnel comportant des sphères de A dans une matrice de B, ou bien des cylindres de A dans une matrice de B, ou encore des lamelles de A et des lamelles de B intercalées.

Les copolymères à blocs ont donc la propriété de former des motifs qui peuvent être contrôlés grâce au ratio de monomères. En outre, la périodicité des motifs formés par les copolymères à blocs est directement reliée à la masse molaire des copolymères à blocs, de sorte qu'en contrôlant cette masse molaire, on peut contrôler la résolution des motifs qu'ils forment.

Ces propriétés des copolymères à blocs sont utilisées dans le cadre des procédés de grapho-épitaxie. Les procédés de grapho-épitaxie consistent généralement à réaliser des motifs de guidage à la surface d'un substrat, ces motifs de guidage définissant des cavités à l'intérieur desquelles les copolymères à blocs vont être déposés pour former des motifs secondaires de meilleure résolution.

Toutefois, il est difficile de contrôler l'orientation des motifs secondaires par rapport aux motifs de guidage.

En effet, l'orientation des motifs secondaires par rapport aux motifs de guidage dépend des interactions des blocs de monomère du copolymère à blocs avec les surfaces du motif de guidage, avec celles du substrat et avec l'air.

Si le guide présente la même affinité préférentielle avec une des deux phases du copolymère à blocs au fond et sur les parois de la cavité de guidage, alors cette phase va s'auto-organiser à l'interface avec le guide. Ainsi le domaine qui devrait être enlevé préférentiellement lors de l'étape de révélation ne traversera pas la hauteur entière du motif de guidage et une couche résiduelle de l'autre phase du polymère va se former à l'interface avec le substrat. Ceci sera une limitation pour le transfert par gravure des copolymères à blocs par la suite.

Le cas le plus avantageux est de générer des motifs de guidage présentant un fond de la cavité neutre (interaction équivalentes des deux blocs avec le substrat) et avec des bords de la cavité préférentiellement affines avec une des deux phases du polymère. Dans ce cas le domaine du polymère sacrificiel qui va être retiré sélectivement lors de l'étape de révélation, traverse toute l'épaisseur jusqu'à l'interface avec le substrat, ce qui est très avantageux pour l'étape de transfert des motifs dans le substrat par gravure (ref R. Tiron et al, SPIE 2015).

De plus, dans le cas d'un copolymère à blocs type A-b-B le contrôle des énergies d'interaction avec la surface peut se faire par exemple en greffant des copolymères statistiques type A-r-B de composition judicieusement choisie (ref X. Chevalier et al, SPIE 2011).

Des procédés de l'art antérieur ont proposé de contrôler ces interactions en greffant un polymère statistique au fond de la cavité tandis que les parois de la cavité restent nues. Pour ce faire, le polymère statistique est dilué puis il est déposé par dépôt à la tournette (également appelé « spin coating »). Lors du recuit de greffage, une faible épaisseur du polymère statistique se fixe alors sur le fond de la cavité tandis que les parois de la cavité restent nues. Toutefois, lorsque sur le même substrat de silicium on a des motifs de guidage avec des densités variables, même si le procédé fonctionne pour un motif donné, pour des guides avec une densité plus importantes, cette technique ne marche pas car la couche de polymère statistique se dépose aussi sur les parois de la cavité. Dans l'art antérieur, les documents US2014256145 et EP2276690 décrivent des méthodes de fabrication d'une structure de guidage utilisant un bloc copolymère comme matériau de self assemblage. Les documents US4379001 et WO2014/256145 décrivent des procédés microélectroniques de gravure d'une couche à graver. La publication "Template affinity role in CH shrink by DSA planarization", de R. Tiron et al., publié le 19 mars 2015 (proceedings of SPIE, vol. 9423, page 942317), propose de réaliser des couches de polymère horizontale et verticales présentant des affinités différentes.

### EXPOSE DE L'INVENTION

L'invention vise à remédier aux inconvénients de l'état de la technique en proposant un procédé permettant de former un motif de guidage pour la grapho-épitaxie dans lequel le fond et les parois des cavités du motif de guidage sont fonctionnalisées différemment, quelle que soit la densité du motif de guidage.

Pour ce faire, est proposé selon un premier aspect de l'invention, un procédé de formation d'un motif de guidage fonctionnalisé destiné à l'auto-assemblage d'un copolymère à blocs par grapho-épitaxie, ce procédé de formation comportant les étapes suivantes :
- formation sur un substrat d'une première couche de fonctionnalisation en un premier matériau présentant une première affinité chimique vis-à-vis du copolymère à blocs ;
- dépôt d'une couche protectrice sur la première couche de fonctionnalisation ;
- formation d'un motif de guidage sur la couche protectrice, le motif de guidage comportant au moins une cavité débouchant sur la couche protectrice, la cavité comportant un fond et des parois latérales ;
- implantation d'ions ayant un numéro atomique inférieur à 10 dans une partie de la couche protectrice située au fond de la cavité par exposition à un bombardement d'ions, de façon à ce que la partie implantée de la couche protectrice puisse être gravée sélectivement par rapport à la partie non implantée de la couche protectrice ;
- formation dans la cavité d'une deuxième couche de fonctionnalisation en un deuxième matériau présentant une deuxième affinité chimique vis-à-vis du copolymère à blocs, la deuxième couche de fonctionnalisation comportant une première partie disposée sur la couche protectrice au fond de la cavité et une deuxième partie disposée sur les parois latérales de la cavité ; et
- gravure de la partie implantée de la couche protectrice et de la première partie de la deuxième couche de fonctionnalisation sélectivement par rapport à la partie non implantée de la couche protectrice, la deuxième partie de la deuxième couche de fonctionnalisation et la première couche de fonctionnalisation, de façon à exposer une partie de la première couche de fonctionnalisation située au fond de la cavité.

Le procédé permet donc de former un motif de guidage comportant au moins une cavité dont le fond est fonctionnalisé avec une première couche de fonctionnalisation et dont les parois latérales sont fonctionnalisées avec une deuxième couche de fonctionnalisation. Ce procédé est efficace quelle que soit la densité des cavités dans le motif de guidage.

Les première et deuxième couches de fonctionnalisation permettent de contrôler l'affinité du copolymère à blocs qui sera déposé dans la cavité avec respectivement le fond et les parois latérales de la cavité.

Le procédé est particulièrement avantageux car la couche protectrice permet de protéger la première couche de fonctionnalisation des étapes ultérieures du procédé. Le motif de guidage est ensuite formé sur la couche protectrice. Le motif de guidage définit au moins une cavité dans laquelle le copolymère à blocs sera déposé. En outre, la cavité est traversante de sorte qu'une partie de la couche protectrice est exposée. Le motif de guidage sert donc également de masque au travers duquel cette partie de la couche protectrice va pouvoir être modifiée de façon à pouvoir être gravée sélectivement par rapport au reste de la couche protectrice, et par rapport au substrat et au motif de guidage. Lors de l'étape de modification de la partie de la couche protectrice à graver, des ions légers sont implantés dans la partie exposée au bombardement d'ions.

En outre, la couche protectrice permet de ne pas greffer la deuxième couche de fonctionnalisation à la place de la première couche de fonctionnalisation lors de la formation de la deuxième couche de fonctionnalisation en évitant que les deux couches de fonctionnalisation soient en contact.

La première partie de la deuxième couche de fonctionnalisation est éliminée lors de l'étape de gravure sélective de la partie implantée de la couche protectrice. Par contre, lors de cette étape, la deuxième partie de la deuxième couche de fonctionnalisation n'est pas gravée.

Le procédé selon le premier aspect de l'invention peut également présenter une ou plusieurs des caractéristiques ci-après prises individuellement ou selon toutes les combinaisons techniquement possibles.

Selon différents modes de réalisation :
- l'étape de formation de la deuxième couche de fonctionnalisation peut avoir lieu après l'étape d'implantation d'ions ; ou alors
- l'étape de formation de la deuxième couche de fonctionnalisation peut avoir lieu avant l'étape d'implantation d'ions.

Avantageusement, l'étape de formation de la première couche de fonctionnalisation comporte les sous-étapes suivantes :
- dépôt d'une couche d'un premier polymère, de préférence par dépôt à la tournette ;
- greffage de la couche du premier polymère sur le substrat, de préférence par recuit thermique ou photo-réticulation ;
- rinçage à l'aide d'un solvant.

Avantageusement, l'étape de formation du motif de guidage comporte les sous-étapes suivantes :
- dépôt d'au moins une couche de base sur la couche protectrice ;
- gravure de la couche de base par lithographie.

Plus précisément, l'étape de formation du motif de guidage peut comporter les sous-étapes suivantes :
- dépôt d'une couche SOC (Spin On Carbon) sur la couche protectrice ;
- recuit de réticulation ;
- dépôt d'une couche de réticulation SiARC (Silicon containing antireflecting coating) sur la couche SOC ;
- recuit de réticulation ;
- dépôt d'une couche de résine sur la couche de SiARC ;
- formation d'un motif en résine ;
- transfert du motif en résine dans les couches SiARC/SOC par gravure de façon à former le motif de guidage.

Cette technique permet de fabriquer facilement des motifs de guidage aux dimensions compatibles avec la grapho-épitaxie.

Avantageusement, la couche de base est déposée à une température inférieure à 300°C, et de préférence inférieure à 250°C, afin que le dépôt de la couche de base n'endommage pas la première couche de fonctionnalisation.

Avantageusement, la couche de base comporte du carbone, afin que le motif de guidage ainsi formé ne soit pas modifié par les étapes ultérieures du procédé.

Avantageusement, la couche protectrice est une couche d'un matériau inorganique diélectrique comportant du silicium, ce qui permet de pouvoir la graver sélectivement par rapport à un motif de guidage en carbone. Une telle couche présente en outre l'avantage de pouvoir être déposée à une température inférieure à 300°C, et de préfère à 250°C, afin de ne pas abîmer la première couche de fonctionnalisation lors du dépôt de la couche protectrice.

Avantageusement, la couche protectrice présente une épaisseur comprise entre 5 et 15 nm et de préférence entre 5 et 10 nm, afin de protéger la première couche de fonctionnalisation et de pouvoir être modifiée localement afin que la partie modifiée localement puisse être gravée sélectivement.

Selon différents modes de réalisation :
- l'implantation d'ions est effectuée par exposition à un plasma, les ions implantés comportant de l'hydrogène et/ou de l'hélium. Dans ce cas, l'implantation peut être effectuée dans un réacteur à gravure sèche ou dans un réacteur à immersion plasma. Ce mode de réalisation permet de modifier une partie de la couche protectrice de façon à pouvoir la graver sélectivement par rapport à la partie non modifiée de la couche protectrice, sans toutefois que le procédé de modification consomme par pulvérisation physique la partie modifiée de la couche protectrice ;
- l'implantation d'ions peut être effectuée par exposition à un faisceau d'ions, les ions implantés comportant une des espèces suivantes : Ar, H, He, N₂.

Selon un premier mode de réalisation, la gravure sélective peut être une gravure humide effectuée à l'aide d'une solution de gravure à base d'acide fluorhydrique ou d'acide phosphorique. En effet, la gravure humide présente l'avantage d'avoir une sélectivité supérieure à 4 entre le matériau exposé au bombardement ionique et le matériau non exposé.

Selon un deuxième mode de réalisation, la gravure sélective peut être une gravure sèche effectuée à l'aide d'un plasma délocalisé, l'étape de gravure comportant les sous-étapes suivantes :
- une première sous-étape de formation d'un sel à partir d'un plasma ;
- une deuxième sous-étape de sublimation du sel.

La gravure sèche est intéressante lorsque la couche protectrice est réalisée en SiN car on peut alors avoir une très bonne sélectivité entre la partie exposée et la partie non exposée.

Avantageusement, le sel est formé à partir d'un plasma à base de fluor et d'hydrogène.

Avantageusement, le sel est de préférence sublimé par un recuit.

Selon un troisième mode de réalisation, la gravure sélective peut être une gravure en phase vapeur. La gravure vapeur présente l'avantage d'avoir une meilleure sélectivité supérieure à 30 entre la partie exposée de la couche protectrice et la partie non exposée de la couche protectrice. Cependant les sels formés en surface nécessitent une étape de nettoyage supplémentaire (à l'eau ou recuit) pour retirer ces sels. Cette étape de nettoyage ne consomme pas la partie non exposée de la couche protectrice.

Selon différentes variantes de réalisation :
- la gravure en phase vapeur peut comporter une étape d'injection d'acide fluorhydrique en phase vapeur dilué dans un solvant sur les couches à graver ;
- la gravure en phase vapeur peut comporter les sous-étapes suivantes :
   ∘ injection d'un gaz d'acide fluorhydrique dans une chambre de réaction dans laquelle se trouvent les couches à graver ;
   ∘ injection d'un gaz inerte dans la chambre de réaction.

Avantageusement, le procédé peut comporter une étape de pré-recuit avant l'étape de gravure vapeur, afin de supprimer l'humidité à la surface des couches à graver, ce qui permet d'avoir une meilleure sélectivité.

Lorsque la gravure vapeur forme des produits de réaction non volatiles, le procédé peut également comporter en outre une étape de suppression des produits de réaction non volatiles formés pendant la gravure vapeur.

L'étape de suppression des produits de réaction non volatiles peut comporter :
- une étape de solubilisation desdits produits dans une solution d'élimination, de préférence de l'eau ; et/ou
- une étape de recuit à une température comprise entre 100°C et 300°C.

Avantageusement, l'étape de formation de la deuxième couche de fonctionnalisation comporte les sous-étapes suivantes :
- dépôt d'une couche d'un deuxième polymère de façon à former une couche du deuxième polymère qui recouvre entièrement le motif de guidage. Ce dépôt est de préférence effectué par dépôt à la tournette ;
- greffage de la couche du deuxième polymère dans la cavité, de préférence par recuit thermique ou photo-réticulation ;
- rinçage à l'aide d'un solvant.

Un deuxième aspect de l'invention concerne un procédé de grapho-épitaxie comportant un procédé de formation d'un motif de guidage fonctionnalisé selon le premier aspect de l'invention et une étape de dépôt d'un copolymère à blocs dans la cavité.

Avantageusement, le copolymère à blocs comporte au moins deux blocs de monomères et la première couche de fonctionnalisation présentant une affinité équivalente avec tous les blocs de monomères.

Avantageusement, la deuxième couche de fonctionnalisation présente une affinité préférentielle avec un des blocs de monomères.

On peut ainsi réaliser des motifs secondaires grâce au copolymère à blocs qui présentent une orientation perpendiculaire au substrat.

### BRÈVE DESCRIPTION DES FIGURES

D'autres caractéristiques et avantages de l'invention ressortiront à la lecture de la description détaillée qui suit, en référence aux figures 1a à 1f annexées, qui illustrent différentes étapes d'un procédé selon un mode de réalisation de l'invention.
La figure 2 représente schématiquement un motif de guidage fonctionnalisé obtenu par le procédé des figures 1a à 1f.
La figure 3 représente la tension de polarisation à utiliser pour différentes épaisseurs d'une couche protectrice en SiN lorsque le plasma est de l'hydrogène, de l'hélium, ou un mélange dihydrogène-hélium.

Pour plus de clarté, les éléments identiques ou similaires sont repérés par des signes de références identiques sur l'ensemble des figures.

### DESCRIPTION DÉTAILLÉE D'AU MOINS UN MODE DE REALISATION

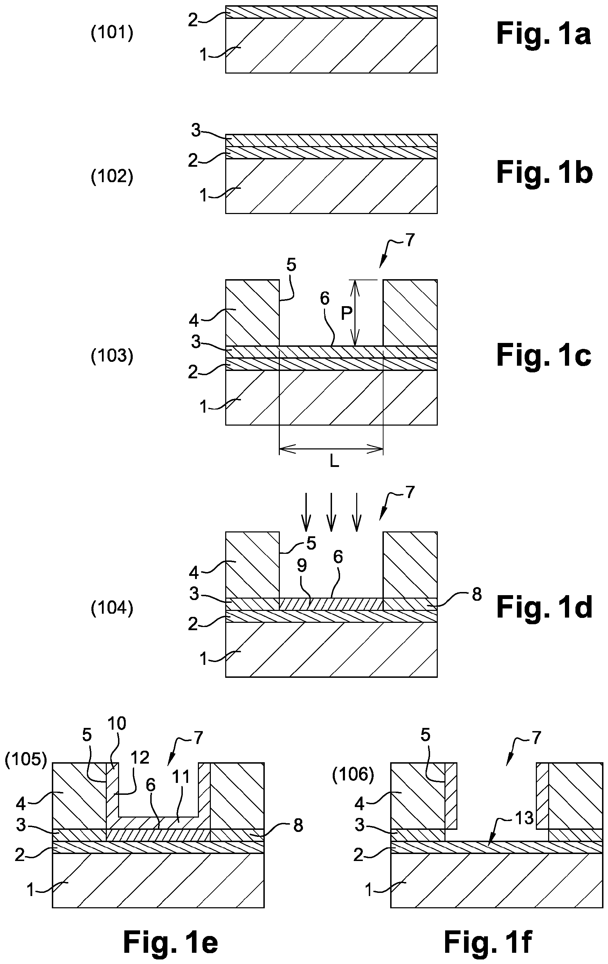

Les figures 1a à 1f représentent les étapes d'un procédé de fabrication d'un motif de guidage pour grapho-épitaxie selon un mode de réalisation de l'invention.

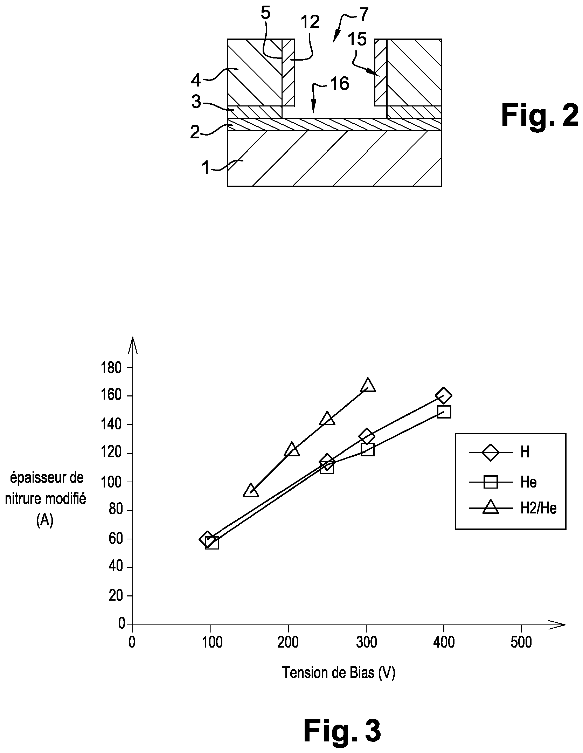

En référence à la figure 2, ce procédé permet d'obtenir un motif de guidage 4 pour grapho-épitaxie comportant au moins une cavité 7 dont le fond 16 est fonctionnalisé de façon à présenter une première affinité avec le copolymère à blocs qui sera déposé dans cette cavité, tandis que les parois latérales 15 sont fonctionnalisées de façon à présenter une deuxième affinité avec le copolymère qui sera déposé dans la cavité.

Pour ce faire, en référence à la figure 1a, le procédé comporte une première étape 101 de formation d'une première couche de fonctionnalisation 2 à la surface du substrat 1. La première couche de fonctionnalisation 2 présente une épaisseur sensiblement constante. La première couche de fonctionnalisation 2 présente une épaisseur de préférence comprise entre 2 et 15 nm, et de manière plus préférentielle entre 5 et 8 nm. La première couche de fonctionnalisation 2 est une couche d'un premier polymère. La composition de ce premier polymère est choisie en fonction de l'affinité qu'on souhaite obtenir entre le fond 16 de la cavité 7 et les blocs de monomères du copolymère à blocs qui sera déposé dans cette cavité. Le premier polymère est également choisi en fonction du substrat. Selon différents modes de réalisation, le premier polymère peut être un copolymère statistique, un homopolymère ou tout autre type de polymère greffable pouvant être utilisé pour contrôler des énergies des surfaces, comme par exemple une monocouche auto-assemblée (également appelées SAM pour « self-assembled monolayer »). Le premier polymère pourrait également être un polymère réticulable. Selon un mode de réalisation préférentiel, le premier polymère peut être choisi de façon à ce que les forces d'attraction entre chacun des blocs de monomères du copolymère à blocs et la première couche de fonctionnalisation soient équivalentes. Dans ce cas, lorsque le copolymère à blocs qui sera déposé dans la cavité est du PS-b-PMMA de morphologie cylindrique, la première couche de fonctionnalisation pourra être une couche de PS-r-PMMA, comportant 70% en masse de polystyrène (PS) et 30% en masse de polyméthacrylate de méthyle (PMMA). Selon un autre mode de réalisation, lorsque le copolymère à blocs qui sera déposé dans la cavité est du PS-b-PMMA de morphologie lamellaire, la première couche de fonctionnalisation pourra être une couche de PS-r-PMMA, comportant 50% en masse de polystyrène (PS) et 50 % en masse de poly méthacrylate de méthyle (PMMA).

L'étape 101 de formation de la première couche de fonctionnalisation 2 comporte de préférence une sous-étape de dépôt d'une couche du premier polymère, par exemple par dépôt à la tournette (également appelé « spin-coating » en anglais). Le dépôt à la tournette peut être effectué en diluant le premier polymère dans un solvant organique. Lorsque le premier polymère est du PS-r-PMMA, le solvant organique peut être de l'acétate de l'éther monométhylique du propylène glycol (également appelé PGMEA pour « Propylene glycol methyl ether acetate »). La solution du premier polymère dilué dans le solvant organique peut présenter une concentration massique en premier polymère sensiblement égale à 1.5%. L'étape 101 de formation de la première couche de fonctionnalisation 2 peut ensuite comporter une sous-étape de fixation, également appelé greffage, de la couche du premier polymère à la surface du substrat. Ce greffage peut être effectué par recuit thermique ou photo-réticulation. Le recuit thermique est de préférence effectué à une température sensiblement égale à 250°C, typiquement entre 230°C et 260°C, pendant une durée sensiblement égale à 10 minutes, typiquement entre 5 et 15 minutes. Le recuit thermique peut être effectué sur une table chauffante ou dans un four. L'étape 101 de formation de la première couche de fonctionnalisation 2 peut ensuite comporter une sous-étape de rinçage au cours de laquelle le surplus du premier polymère est enlevé à l'aide d'un solvant. Lorsque le premier polymère est du PS-r-PMMA, le solvant utilisé peut être de l'acétate de l'éther monométhylique du propylène glycol (également appelé PGMEA pour « Propylene glycol methyl ether acetate »). Une autre variante de l'étape 101 serait d'utiliser un polymère réticulable. Ainsi après l'étape d'étalement à la tournette le polymère est réticulé pendant un recuit thermique. Cette variante pourrait être utilisée pour les cas où la première couche de fonctionnalisation 2 ne se greffe pas sur le substrat.

En référence à la figure 1b, le procédé comporte ensuite une étape 102 de dépôt d'une couche protectrice 3 sur la première couche de fonctionnalisation 2. Selon un mode de réalisation, la couche protectrice 3 peut être une couche inorganique diélectrique comportant du silicium qui peut être déposée à une température inférieure à 300°C, et de préférence à une température inférieure à 250°C afin de ne pas abimer la première couche de fonctionnalisation lors de son dépôt. Ainsi, la couche protectrice peut être une couche d'un des matériaux suivants : SiN, SiOC, SiO₂, SiCBN. La couche protectrice 3 pourrait également une couche d'un polymère chargé en silicium, comme par exemple une couche antireflet au silicium (également appelée SiARC pour « Silicon-Containing Anti-Reflective Coating »), une couche de HSQ (Ultra Dense hydrogen silsesquioxane) ou encore une couche de poly(diméthylsiloxane) (également appelé PDMS). Selon un autre mode de réalisation, la couche protectrice peut également être une couche de HFO₂ ou de TiN. La couche protectrice 3 présente de préférence une épaisseur comprise entre 5 et 15 nm, et de manière plus préférentielle entre 5 et 10 nm, de façon à présenter une épaisseur suffisante pour protéger la première couche de fonctionnalisation lors des étapes ultérieures du procédé, tout en étant suffisamment mince pour pouvoir être modifiée de façon à ce qu'une partie de cette couche puisse être gravée sélectivement comme expliqué dans la suite. La couche protectrice 3 présente de préférence une épaisseur constante. La couche protectrice 3 peut être déposée par PVD (physical vapor déposition), ALD (Atomic Layer Déposition), PEALD (Plasma-Enhanced Atomic Layer Déposition).

En référence à la figure 1c, le procédé comporte ensuite une étape 103 de formation d'un motif de guidage 4 à la surface de la couche protectrice 3. Le motif de guidage 4 comporte au moins une cavité 7 qui débouche sur la couche protectrice 3. La cavité 7 comporte donc un fond 6 formé par une partie 9 de la couche protectrice 3. La cavité 7 comporte également des parois latérales 5 s'étendant suivant une direction sécante à la surface du substrat. Plus précisément, les parois latérales 5 s'étendent de préférence suivant une direction perpendiculaire à la surface du substrat. La cavité peut présenter différentes géométries. Elle peut ainsi prendre la forme d'un puits cylindrique, d'une tranchée, d'un puits de section rectangulaire, d'un puit elliptique ou encore en forme de ∞ ou toute autre forme permettant le procédé de grapho-épitaxie ensuite. Le motif de guidage 4 est de préférence réalisé dans un matériau résistant aux techniques de gravure utilisées lors des étapes ultérieures du procédé, par exemple un matériau inerte à l'acide fluorhydrique (HF) et/ou à l'acide phosphorique (H₃PO₄). Pour cela, selon un premier mode de réalisation, le motif de guidage peut comporter du carbone. Ainsi, le motif de guidage peut être en carbone déposé par centrifugation (également appelé SOC pour spin-on-carbon) ou en toute autre couche carbonée anti-réflective. Selon un deuxième mode de réalisation, qui peut être combiné ou non avec le premier, le motif de guidage peut être recouvert d'une couche résistante à l'acide fluorhydrique (HF) et/ou à l'acide phosphorique (H₃PO₄), comme par exemple une couche de SiN. Cette couche de SiN peut être déposée par une technique de dépôt conforme. Ce deuxième mode de réalisation permet de réaliser le motif de guidage dans tout type de matériau, comme par exemple en oxyde de silicium, puis de le protéger en déposant dessus une couche résistante aux techniques de gravure utilisées lors des étapes ultérieures du procédé. Chaque cavité 7 présente de préférence une profondeur P comprise entre 50 et 300 nm. Chaque cavité 7 présente de préférence une largeur L comprise entre 30 et 200 nm. L'étape 103 de formation du motif de guidage 4 peut comporter les sous-étapes suivantes :
- dépôt d'une ou plusieurs couches sur la couche protectrice 3 ;
- réalisation d'au moins une cavité 7 à travers cette ou ces couches, de préférence par lithographie, par exemple par photolithographie.

La lithographie est réalisée de façon à ce que la cavité 7 débouche sur la couche protectrice 3.

En référence à la figure 1d, le procédé comporte ensuite une étape 104 de d'implantation d'ions légers dans la partie 9 de la couche protectrice qui forme le fond de la cavité 7 de façon à ce que celle-ci puisse être gravée sélectivement par rapport au reste de la couche protectrice 3. Cette implantation est effectuée en exposant la partie 9 de la couche protectrice à un bombardement d'ions dits « légers », c'est-à-dire dont le numéro atomique est inférieur à 10. A l'issue de cette étape, la partie 9 de la couche protectrice qui a été exposée au bombardement peut donc être gravée sélectivement par rapport à la partie 8 de la couche protectrice qui n'a pas été exposée au bombardement.

Ce bombardement d'ions peut être effectué grâce à un plasma ou un faisceau d'ions.

Ainsi, selon un premier mode de réalisation, cette étape 104 d'implantation peut être effectuée dans un réacteur de gravure sèche ou à immersion plasma. Le réacteur de gravure sèche peut être par exemple être un réacteur à couplage capacitif (également appelé CCP pour « capacitively coupled plasma » c'est-à-dire « plasma à couplage capacitive »), ou un réacteur de gravure à couplage inductif (également appelé ICP de l'anglais « inductively coupled plasma » c'est-à-dire « plasma à couplage inductif »).

Les ions implantés comportent de l'hydrogène et/ou de l'hélium. Pour ce faire, on peut utiliser un plasma comportant un gaz principal, le gaz principal étant un mélange d'un ou plusieurs des gaz suivants : He, H₂, NH₃, HBr, CₓH_{y}, SiH₄. Le plasma peut également comporter un gaz de dissociation, tel que l'argon, l'hélium, le xénon, le diazote, permettant de faciliter la dissociation du gaz principal et par ce biais, de favoriser l'implantation des ions légers dans la couche protectrice.

Les conditions d'implantation sont choisies de façon à ce que la partie 9 de la couche protectrice qui forme le fond de la cavité 7 puisse être gravée sélectivement par rapport au reste de la couche protectrice 3. Ainsi, à titre d'exemple, le tableau ci-après donne des conditions typiques de mise en œuvre de l'étape 104 de modification de la couche protectrice 3 dans le cas d'utilisation d'un réacteur de gravure plasma standard. Ces conditions sont dépendantes de la nature de la couche protectrice 3, de son épaisseur, et du plasma utilisé notamment.

| Débit gaz principal | 10 cm³/minute - 100 cm³/minute |
|---|---|
| Débit gaz de dissociation | 10 cm³/minute - 500 cm³/minute |
| Puissance de la source | 0-2000 W |
| Tension de polarisation | 20 V-500 V |
| Pression | 5 milliTorr-100 milliTorr |
| Température | 10 °C-100°C |
| Durée | 1 seconde-10 minutes |

La durée d'exposition au plasma notamment dépend de l'épaisseur de la couche protectrice 3.

A titre d'exemple, dans le cas où la couche protectrice est une couche de SiN, la figure 3 donne la puissance de polarisation à utiliser en fonction de l'épaisseur de la couche de SiN et en fonction du plasma utilisé, pour trois plasmas : un plasma à base d'hydrogène, un plasma à base d'hélium et un plasma à base de dihydrogène et d'hélium.

Par ailleurs, on peut également pulser la tension de polarisation ou la puissance de la source afin de mieux contrôler la profondeur d'implantation. Le paramètre pulsé est de préférence pulsé à une fréquence comprise entre 100 Hz et 500 Hz selon un cycle opératoire compris entre 10% et 90%. Le fait de pulser la tension de polarisation ou la puissance de la source permet d'avoir des ions moins énergétiques, ce qui est avantageux lorsque la couche protectrice est fine, c'est-à-dire lorsque la couche protectrice présente une épaisseur inférieure à 10 nm.

Selon un deuxième mode de réalisation, l'étape 104 d'implantation peut être effectuée dans un implanteur à faisceau d'ions. On peut alors implanter des ions légers, c'est-à-dire dont le numéro atomique est inférieur à 10, comme par exemple : Ar, H, He, N₂...

Les conditions d'implantation sont également choisies de façon à ce que la partie 9 de la couche protectrice qui forme le fond de la cavité 7 puisse être gravée sélectivement par rapport au reste de la couche protectrice 3. Ces conditions d'implantation peuvent être déterminées à l'aide d'un logiciel permettant de simuler les profils et profondeurs d'implantation d'une espèce donnée dans un matériau donné, par exemple le logiciel SRIM (« Stopping and Range of Ions in Matter ») basé sur une simulation de type Monte-Carlo.

Le procédé peut également comporter une étape 105 de formation d'une deuxième couche de fonctionnalisation 10 dans la cavité. La deuxième couche de fonctionnalisation 10 comporte une première partie dite «partie horizontale» 11 déposée sur le fond 6 de la cavité et une deuxième partie dite « partie verticale » 12 déposée sur les parois latérales 5 de la cavité. La deuxième couche de fonctionnalisation 10 présente une épaisseur sensiblement constante. La deuxième couche de fonctionnalisation 10 présente une épaisseur de préférence comprise entre 2 et 15 nm, et de manière plus préférentielle entre 5 et 12 nm. La deuxième couche de fonctionnalisation 10 est une couche d'un deuxième polymère, différent du premier polymère. La composition de ce deuxième polymère est choisie en fonction des interactions voulues entre les parois latérales de la cavité 7 et le copolymère à blocs qui sera déposé dans cette cavité. Selon différents modes de réalisation, le deuxième polymère peut être un copolymère statistique, un homopolymère ou tout autre type de polymère greffable pouvant être utilisé pour contrôler des énergies des surfaces, comme par exemple une monocouche auto-assemblée (également appelées SAM pour « self-assembled monolayer »). Selon un mode de réalisation préférentiel, le deuxième polymère peut être choisi de façon à avoir une interaction préférentielle entre une des phases A ou B du copolymère à blocs et les parois latérales 12 de la cavité. Pour cela, le deuxième polymère pourra être un homopolymère d'une des phases du copolymère à blocs qui sera déposé dans la cavité. Par exemple, lorsque le copolymère à blocs est PS-b-PMMA, la deuxième couche de fonctionnalisation pourra par exemple être une couche d'un homopolymère de PS ou d'un homopolymère de PMMA. De façon générale, si le copolymère à blocs est un polymère type A-b-B, la deuxième couche de fonctionnalisation 10 peut être un homopolymère A ou en homopolymère B, en fonction de ce qu'on cherche à réaliser comme dispositif final.

L'étape 105 de formation de la deuxième couche de fonctionnalisation 10 comporte de préférence une sous-étape de dépôt d'une couche du deuxième polymère, par exemple par dépôt à la tournette (également appelé « spin-coating » en anglais). Le dépôt à la tournette peut être effectué en diluant le deuxième polymère dans un solvant organique. Ce solvant organique est de préférence de l'acétate de l'éther monométhylique du propylène glycol (également appelé PGMEA pour « Propylene glycol methyl ether acetate »). Cette première sous-étape de dépôt est effectuée de façon à ce que l'épaisseur du deuxième polymère déposé soit suffisamment importante pour recouvrir entièrement le motif de guidage. La concentration de solution du deuxième polymère et la vitesse de dépôt seront donc choisies en fonction de la hauteur du motif de guidage 4, de façon à ce qu'à la fin de l'étape de dépôt du deuxième polymère, la couche du deuxième polymère recouvre entièrement le motif de guidage 4.

Par exemple, lorsque la cavité 7 présente une profondeur P de 150 nm, on peut utiliser une solution du deuxième polymère présentant une concentration massique du deuxième polymère de 5%.

L'étape 105 de formation de la deuxième couche de fonctionnalisation 10 comporte ensuite de préférence une sous-étape de fixation, également appelé greffage, de la couche du deuxième polymère sur le motif de guidage. Ce greffage peut être effectué par recuit thermique ou photo-réticulation. Le recuit thermique peut être effectué sur une table chauffante ou dans un four. L'étape 105 de formation de la deuxième couche de fonctionnalisation 10 peut ensuite comporter une sous-étape de rinçage au cours de laquelle le surplus du premier polymère est enlevé à l'aide d'un solvant. Lorsque le deuxième polymère est du PS ou PMMA, le solvant utilisé peut être de l'acétate de l'éther monométhylique du propylène glycol (également appelé PGMEA pour « Propylene glycol methyl ether acetate »).

Avantageusement, le deuxième polymère est greffé à plus faible température que le premier polymère (typiquement entre 150 et 170°C) et/ou pendant un temps plus court (typiquement inférieur à 3 voire 2 minutes) de sorte que la densité d'espèces greffées soit plus faible, laissant des accès plus importants au matériau sous-jacent.

Le procédé comporte ensuite une étape 106 de gravure de la partie 9 de la couche protectrice qui a été modifiée, de façon à exposer la première couche de fonctionnalisation 2 au fond de la cavité. Lorsqu'une deuxième couche de fonctionnalisation a été formée, la partie horizontale de la deuxième couche de fonctionnalisation est également éliminée lors de cette étape par effet de soulèvement (ou effet « lift-off »), la gravure de la couche protectrice sous-jacente entrainant l'élimination de la partie horizontale de la deuxième couche de fonctionnalisation greffée sur la couche protectrice. Le substrat 1 et le motif de guidage 4 sont inertes à cette étape de gravure. La partie de la couche protectrice 3 qui n'a pas été modifiée lors de l'étape 104 n'est pas altérée par cette étape de gravure, tout comme la partie verticale de la deuxième couche de fonctionnalisation, en raison du caractère sélectif de la gravure (i.e. la gravure est spécifique au matériau implanté de la couche protectrice).

La gravure est effectuée de façon à ce qu'à la fin de cette étape, le fond de la cavité soit formé par une partie 13 de la première couche de fonctionnalisation 2 (avantageusement neutre vis-à-vis du copolymère que l'on souhaite organisé) tandis que les parois de la cavité sont recouvertes de la partie verticale de la deuxième couche de fonctionnalisation (présentant de préférence une affinité particulière vis-à-vis d'une des phases du copolymère). Pour ce faire, différentes techniques de gravure peuvent être utilisées. Les techniques de gravure choisies dépendent notamment de la constitution de la couche protectrice.

Ainsi, selon un premier mode de réalisation, la gravure peut être une gravure humide. Lorsque la couche protectrice 3 est une couche de SiOC, SiO₂, SiCBN, HFO₂, la gravure humide peut être effectuée à l'aide d'une solution de gravure à base d'acide fluorhydrique. Lorsque la couche protectrice 3 est une couche de SiN, la gravure humide peut être effectuée à l'aide d'une solution de gravure à base d'acide fluorhydrique ou d'acide phosphorique.

Dans le cas d'une solution de gravure à base d'acide fluorhydrique, la solution de gravure est de préférence diluée à 1%. La durée d'exposition des couches à graver à la solution de gravure dépend de l'épaisseur des couches à graver et de la concentration de la solution de gravure. Elle varie généralement entre 1 seconde et 10 minutes.

Par exemple, dans le cas où la couche protectrice est une couche de SiN de 10nm, la durée d'exposition est de l'ordre de 30 secondes, à la fois pour une solution de gravure à base d'acide fluorhydrique ou d'acide phosphorique.

Lorsque la couche protectrice est une couche de TiN, la partie exposée de la couche protectrice peut être gravée par une solution alcaline (SC1).

Selon un deuxième mode de réalisation, la gravure peut être une gravure sèche. On utilise pour cela un plasma délocalisé. L'étape de gravure comporte alors de préférence deux sous-étapes :
- une première sous-étape de formation d'un sel à partir d'un plasma ;
- une deuxième sous-étape de sublimation du sel.

Le sel est de préférence formé à partir d'un plasma à base de fluor et d'hydrogène. On peut pour cela utiliser du trifluorure d'azote d'une part et du dihydrogène ou de l'ammoniac d'autre part. Le sel peut être formé en plaçant le plasma pendant une durée comprise entre 1 et 5 secondes à 2 Torr, à une température inférieure à 100°C.

Le sel est de préférence sublimé par un recuit. Le recuit est de préférence effectué à une température supérieure à 100°C et de préférence comprise entre 150°C et 200°C.

Par exemple, lorsque la couche protectrice est une couche de SiN de 10 nm d'épaisseur, la gravure sèche peut comporter les sous-étapes suivantes :
- une sous-étape de formation d'un sel grâce à plasma réalisé avec un débit de NH₃ compris entre 50 et 300 cm³/minutes, à 30°C pendant 45 secondes ;
- une étape de sublimation du sel grâce à un recuit à 180°C pendant une minute.

Selon un troisième mode de réalisation, la gravure peut être effectuée en phase vapeur.

Pour ce faire, selon une première variante de réalisation, on peut utiliser de l'acide fluorhydrique en phase vapeur dilué dans un solvant. Cette approche permet une meilleure sélectivité vis-à-vis de la partie non exposée de la couche protectrice. Une étape de nettoyage est alors nécessaire pour enlever les sels formés après l'étape de gravure.

Selon une deuxième variante de réalisation, un gaz d'acide fluorhydrique peut être injecté dans une chambre de réaction dans laquelle se trouvent les couches à graver. Un gaz inerte est simultanément injecté dans la chambre de réaction. Ce gaz inerte permet d'ajuster le ratio d'acide fluorhydrique injecté dans la chambre de réaction, et donc la vitesse de gravure. Le ratio d'acide fluorhydrique injecté dans la chambre de réaction est de préférence compris entre 10% et 90%. Les débits de chacun des deux gaz peuvent être contrôlés indépendamment. Cette gravure peut être effectuée à pression et température ambiante ou à une pression inférieure à la pression ambiante et à une température supérieure à la température ambiante. Selon un mode de réalisation préférentiel, la température est comprise entre 15°C et 80°C et la pression est comprise entre 40 Torr et 760 Torr. La durée de gravure dépend de l'épaisseur à graver. Elle est de préférence comprise entre 1 seconde et 10 minutes.

A titre d'exemple, lorsque la couche protectrice est une couche de SiN de 10 nm d'épaisseur, la gravure vapeur peut être effectuée en injectant 31% de gaz d'acide fluorhydrique et 69% de diazote, à pression et température ambiante, pendant deux minutes.

Optionnellement un pré-recuit peut être effectué avant la gravure vapeur pour éliminer toute humidité du substrat. Ce pré-recuit est de préférence effectué à une température supérieure à 100°C. La durée entre le pré-recuit et la gravure vapeur est de préférence inférieure à une heure afin de limiter la reprise d'eau. Pour cela, le pré-recuit et la gravure vapeur sont de préférence effectués dans le même appareil.

Par ailleurs, suite à la gravure vapeur, on effectue de préférence un post-traitement permettant de supprimer tous les produits de réaction non volatiles qui ont été créés pendant la gravure vapeur.

Pour ce faire, selon une première variante de réalisation, les produits de réaction peuvent être éliminés en les solubilisant. Pour cela, on peut rincer le substrat à l'aide d'eau, de préférence dé-ionisée, par exemple pendant 10 minutes. L'eau peut circuler ou être vaporisée sur le substrat.

Selon une deuxième variante, les produits de réaction peuvent être éliminés en les volatilisant. Pour ce faire, on peut faire un recuit à basse pression. A titre d'exemple, ce recuit peut être effectué à une température de 200°C, une pression de 1.5 Torr, en injectant un gaz comportant du diazote et 4% de dihydrogène avec un débit de 2000 cm³/minute, pendant 180 secondes.

Le procédé permet donc de fabriquer un motif de guidage pourvu d'une cavité dont le fond est fonctionnalisé avec une première couche de fonctionnalisation tandis que les parois latérales sont fonctionnalisées avec une deuxième couche de fonctionnalisation.

Le motif de guidage peut ensuite être utilisé dans un procédé de grapho-épitaxie, et notamment dans un procédé d'auto-assemblage dirigé de copolymères à blocs (« Directed Self-Assembly », DSA) afin de générer des motifs de très hautes résolution et densité.

Le procédé de grapho-épitaxie peut alors comporter une étape de dépôt d'un copolymère à blocs dans la cavité du motif de guidage.

Ce copolymère à blocs pourrait notamment être un des suivants :
- PS-b-PMMA : polystyrène-block-olyméthylméthacrylate,
- PS-b-PLA : polystyrène-block- acide polylactique,
- PS-b-PEO : polystyrène-block-polyoxyde d'éthylène,
- PS-b-PDMS : polystyrène-block-polydiméthylsiloxane,
- PS-b-PMMA-b-PEO : polystyrène-block-polyméthylméthacrylate-block-polyoxyde d'éthylène,
- PS-b-P2VP : polystyrène-block-poly(2vinylpyridine).

Le copolymère à blocs n'a pas les mêmes affinités avec la première couche de fonctionnalisation et avec la deuxième couche de fonctionnalisation de sorte que la présence de ces couches de fonctionnalisation permet de contrôler l'orientation du motif secondaire réalisé grâce au copolymère à blocs dans la cavité.

Naturellement, l'invention n'est pas limitée aux modes de réalisation décrits en référence aux figures et des variantes pourraient être envisagées sans sortir du cadre de l'invention. Les couches de fonctionnalisation pourraient ainsi présenter d'autres compositions que celles décrites précédemment. De même, d'autres copolymères à blocs pourraient être utilisés. L'invention n'est pas non plus limitée aux solvants donnés à titre d'exemple dans la description détaillée. Par ailleurs, l'invention a été décrite dans le cas où le motif de guidage comporte une seule cavité. Toutefois, elle est applicable quel que soit le nombre de cavités dans le motif de guidage.

En outre, l'invention a été décrite dans le cas où le procédé comporte une étape de formation d'une deuxième couche de fonctionnalisation. Toutefois, cette étape n'est pas obligatoire. Par ailleurs, l'invention a été décrite dans le cas où l'étape 105 de formation de la deuxième couche de fonctionnalisation est effectuée après l'étape 104 d'implantations d'ions. Toutefois, l'ordre de ces étapes pourrait être inversé. Ainsi, l'implantation d'ions pourra avoir lieu également dans la partie horizontale de la deuxième couche de fonctionnalisation sans que cela ait une incidence sur la suite du procédé, et notamment sur l'étape de gravure sélective.

## Revendications

1. Procédé de formation d'un motif de guidage fonctionnalisé destiné à l'auto-assemblage d'un copolymère à blocs par grapho-épitaxie, le procédé de formation comportant les étapes suivantes :
- (101) formation sur un substrat (1) d'une première couche de fonctionnalisation (2) en un premier matériau présentant une première affinité chimique vis-à-vis du copolymère à blocs ;
- (102) dépôt d'une couche protectrice (3) sur la première couche de fonctionnalisation (2) ;
- (103) formation d'un motif de guidage (4) sur la couche protectrice (3), le motif de guidage (4) comportant au moins une cavité (7) débouchant sur la couche protectrice (3), la cavité (7) comportant un fond (6) et des parois latérales (5) ;
- (104) implantation d'ions ayant un numéro atomique inférieur à 10 dans une partie (9) de la couche protectrice (3) située au fond de la cavité par exposition à un bombardement d'ions, de façon à ce que la partie implantée (9) de la couche protectrice puisse être gravée sélectivement par rapport à la partie non implantée (8) de la couche protectrice ;
- (105) formation dans la cavité (7) d'une deuxième couche de fonctionnalisation (10) en un deuxième matériau présentant une deuxième affinité chimique vis-à-vis du copolymère à blocs, la deuxième couche de fonctionnalisation (10) comportant une première partie (11) disposée sur la couche protectrice (3) au fond (6) de la cavité et une deuxième partie (12) disposée sur les parois latérales (5) de la cavité ; et
- (106) gravure de la partie implantée (9) de la couche protectrice et de la première partie (11) de la deuxième couche de fonctionnalisation (10) sélectivement par rapport à la partie non implantée (8) de la couche protectrice (3), la deuxième partie (12) de la deuxième couche de fonctionnalisation (10) et la première couche de fonctionnalisation (2), de façon à exposer une partie (13) de la première couche de fonctionnalisation située au fond de la cavité.

2. Procédé selon la revendication précédente, dans lequel l'étape (103) de formation du motif de guidage (4) comporte les sous-étapes suivantes :
- dépôt d'au moins une couche de base sur la couche protectrice ;
- gravure de la couche de base par lithographie.

3. Procédé selon la revendication 2, dans lequel la couche de base est déposée à une température inférieure à 300°C, et de préférence inférieure à 250°C.

4. Procédé selon l'une des revendications 2 ou 3, dans lequel la couche de base comporte du carbone.

5. Procédé selon l'une des revendications précédentes, dans lequel la couche protectrice (3) est une couche d'un matériau inorganique diélectrique comportant du silicium.

6. Procédé selon l'une des revendications 1 à 5, dans lequel l'implantation d'ions est effectuée par exposition à un plasma, les ions implantés comportant de l'hydrogène et/ou de l'hélium.

7. Procédé selon l'une des revendications 1 à 5, dans lequel l'implantation d'ions est effectuée par exposition à un faisceau d'ions, les ions implantés comportant une des espèces suivantes : Ar, H, He, N₂.

8. Procédé selon l'une des revendications 1 à 7, dans lequel la gravure sélective est une gravure humide effectuée à l'aide d'une solution de gravure à base d'acide fluorhydrique ou d'acide phosphorique.

9. Procédé selon l'une des revendications 1 à 7, dans lequel la gravure sélective est une gravure sèche effectuée à l'aide d'un plasma délocalisé, l'étape de gravure comportant les sous-étapes suivantes :
- une première sous-étape de formation d'un sel à partir d'un plasma ;
- une deuxième sous-étape de sublimation du sel.

10. Procédé selon la revendication 9, dans lequel le sel est formé à partir d'un plasma à base de fluor et d'hydrogène.

11. Procédé selon l'une des revendications 9 ou 10, dans lequel le sel est sublimé par un recuit.

12. Procédé selon l'une des revendications 1 à 7, dans lequel la gravure sélective est une gravure en phase vapeur.

13. Procédé selon la revendication 12, dans lequel la gravure en phase vapeur comporte une étape d'injection d'acide fluorhydrique en phase vapeur dilué dans un solvant sur les couches à graver.

14. Procédé selon la revendication 12, dans lequel la gravure en phase vapeur comporte les sous-étapes suivantes :
- injection d'un gaz d'acide fluorhydrique dans une chambre de réaction dans laquelle se trouvent les couches à graver ;
- injection d'un gaz inerte dans la chambre de réaction.

15. Procédé selon l'une des revendications 12 à 14, comportant en outre une étape de pré-recuit avant l'étape de gravure vapeur.

16. Procédé selon l'une des revendications 12 à 15, dans lequel la gravure vapeur forme des produits de réaction non volatiles, le procédé comportant en outre une étape de suppression des produits de réaction non volatiles formés pendant la gravure vapeur, l'étape de suppression des produits de réaction non volatiles comportant :
- une étape de solubilisation desdits produits dans une solution d'élimination, de préférence de l'eau ; et/ou
- une étape de recuit à une température comprise entre 100°C et 300°C.

17. Procédé de grapho-épitaxie comportant un procédé de formation d'un motif de guidage fonctionnalisé selon l'une des revendications 1 à 16 et une étape de dépôt d'un copolymère à blocs dans la cavité.

18. Procédé de grapho-épitaxie selon la revendication précédente, dans lequel le copolymère à blocs comporte au moins deux blocs de monomères, la première couche de fonctionnalisation présentant une affinité équivalente avec tous les blocs de monomères, la deuxième couche de fonctionnalisation présentant une affinité préférentielle avec un des blocs de monomères.

## Patentansprüche

1. Bildungsverfahren eines funktionalisierten Führungsmusters, das zur Selbstmontage eines Block-Kopolymers per Graphoepitaxie bestimmt ist, wobei das Bildungsverfahren die folgenden Schritte umfasst:
- (101) Bildung einer ersten Funktionalisierungsschicht (2) aus einem ersten Material, das eine erste chemische Affinität gegenüber dem Blockpolymer aufweist, auf einem Substrat (1);
- (102) Aufbringen einer Schutzschicht (3) auf der ersten Funktionalisierungsschicht (2);
- (103) Bildung eines Führungsmusters (4) auf der Schutzschicht (3), wobei das Führungsmuster (4) wenigstens eine Ausnehmung (7) umfasst, die in die Schutzschicht (3) mündet, wobei die Ausnehmung (7) einen Boden (6) und Seitenwände (5) umfasst;
- (104) Einsatz von Ionen mit einer Atomzahl von weniger als 10 in einen Teil (9) der Schutzschicht (3), die sich im Boden der Ausnehmung befindet, durch Kontaktieren mit einem lonenbeschuss derart, dass der eingesetzte Teil (9) der Schutzschicht in Bezug auf den nicht eingesetzten Teil (8) der Schutzschicht selektiv geätzt wird;
- (105) Bildung einer zweiten Funktionalisierungsschicht (10) aus einem zweiten Material, das eine zweite chemische Affinität gegenüber dem Block-Kopolymer aufweist, in der Ausnehmung (7), wobei die zweite Funktionierungsschicht (10) einen ersten Teil (11), der auf der Schutzschicht (3) im Boden (6) der Ausnehmung angeordnet ist, und einen zweiten Teil (12), der auf den Seitenwänden (5) der Ausnehmung angeordnet ist, umfasst; und
- (106) Gravur des eingesetzten Teils (9) der Schutzschicht und des ersten Teils (11) der zweiten Funktionalisierungsschicht (10) selektiv in Bezug auf den nicht eingesetzten Teil (8) der Schutzschicht (3) des zweiten Teils (12) der zweiten Funktionalisierungsschicht (10) und der ersten Funktionalisierungsschicht (2) derart, dass ein Teil (13) der ersten Funktionalisierungsschicht, der im Boden der Ausnehmung angeordnet ist, freigelegt wird.

2. Verfahren gemäß dem voranstehenden Anspruch, bei dem der Schritt (103) zur Bildung des Führungsmusters (4) die folgenden Teilschritte umfasst:
- Aufbringen wenigstens einer Basisschicht auf der Schutzschicht;
- Gravur der Basisschicht per Lithographie.

3. Verfahren gemäß Anspruch 2, bei dem die Basisschicht bei einer Temperatur von unter 300 °C und bevorzugt unter 250 °C aufgebracht wird.

4. Verfahren gemäß einem der Ansprüche 2 oder 3, bei dem die Basisschicht Kohlenstoff umfasst.

5. Verfahren gemäß einem der voranstehenden Ansprüche, bei dem die Schutzschicht (3) eine Schicht aus einem anorganischen, dielektrischen Material ist, das Silizium umfasst.

6. Verfahren gemäß einem der Ansprüche 1 bis 5, bei dem das Einsetzen von Ionen per Kontaktieren mit einem Plasma durchgeführt wird, wobei die eingesetzten Ionen Wasserstoff und/oder Helium umfassen.

7. Verfahren gemäß einem der Ansprüche 1 bis 5, bei dem das Einsetzen von Ionen per Kontaktieren mit einem lonenstrahl durchgeführt wird, wobei die eingesetzten Ionen eines der folgenden Elemente umfassen: Ar, H, He, N₂.

8. Verfahren gemäß einem der Ansprüche 1 bis 7, bei dem die selektive Gravur eine feuchte Gravur ist, die mit Hilfe einer Gravurlösung auf Flusssäure- oder Phosphorsäurebasis durchgeführt wird.

9. Verfahren gemäß einem der Ansprüche 1 bis 7, bei dem die selektive Gravur eine trockene Gravur ist, die mit Hilfe eines delokalisierten Plasmas durchgeführt wird, wobei der Gravurschritt die folgenden Teilschritte umfasst:
- einen ersten Teilschritt zur Bildung eines Salzes ausgehend von einem Plasma;
- einen zweiten Teilschritt zum Sublimieren des Salzes.

10. Verfahren gemäß Anspruch 9, bei dem das Salz ausgehend von einem Plasma auf Fluor- und Wasserstoffbasis gebildet wird.

11. Verfahren gemäß einem der Ansprüche 9 oder 10, bei dem das Salz durch ein Glühen sublimiert wird.

12. Verfahren gemäß einem der Ansprüche 1 bis 7, bei dem die selektive Gravur eine Gravur in der Dampfphase ist.

13. Verfahren gemäß Anspruch 12, bei dem die Gravur in der Dampfphase eine Einspritzphase von Flusssäure in der Dampfphase ist, die in einer Lösung auf den zu ätzenden Schichten verdünnt wird.

14. Verfahren gemäß Anspruch 12, bei dem die Gravur in der Dampfphase die folgenden Teilschritte umfasst:
- Einspritzen eines Flusssäuregases in eine Reaktionskammer, in der die zu ätzenden Schichten angeordnet sind;
- Einspritzen eines inerten Gases in die Reaktionskammer.

15. Verfahren gemäß einem der Ansprüche 12 bis 14, umfassend darüber hinaus einen Vorglüh-Schritt vor dem Dampfgravur-Schritt.

16. Verfahren gemäß einem der Ansprüche 12 bis 15, bei dem die Dampfgravur nicht flüchtige Reaktionsprodukte bildet, wobei das Verfahren darüber hinaus einen Beseitigungsschritt der nicht flüchtigen Reaktionsprodukte umfasst, die während der Dampfgravur gebildet werden, wobei der Beseitigungsschritt der nicht flüchtigen Reaktionsprodukte umfasst:
- einen Solubilisierungsschritt der genannten Produkte in einer Eliminierungslösung, bevorzugt Wasser; und/oder
- einen Glühschritt bei einer zwischen 100 °C und 300 °C inbegriffenen Temperatur.

17. Graphoepitaxieverfahren, umfassend ein Bildungsverfahren eines funktionalisierten Führungsmusters gemäß einem der Ansprüche 1 bis 16 und einen Aufbringungsschritt eines Block-Kopolymers in der Ausnehmung.

18. Graphoexpitaxieverfahren gemäß dem voranstehenden Anspruch, bei dem das Block-Kopolymer wenigstens zwei Monomerblöcke umfasst, wobei die erste Funktionalisierungsschicht eine mit allen Monomerblöcken äquivalente Affinität aufweist, wobei die zweite Funktionalisierungsschicht eine bevorzugte Affinität mit einem der Monomerblöcke aufweist.

## Claims

1. Method for forming a functionalised guide pattern intended for the self-assembly of a block copolymer by graphoepitaxy, the forming method comprising the following steps:
- (101) forming on a substrate (1) a first functionalisation layer (2) made of a first material having a first chemical affinity with respect to the block copolymer;
- (102) depositing a protective layer (3) on the first functionalisation layer (2);
- (103) forming a guide pattern (4) on the protective layer (3), the guide pattern (4) comprising at least one cavity (7) opening onto the protective layer (3), the cavity (7) comprising a bottom (6) and side walls (5);
- (104) implanting ions having an atomic number less than 10 in a portion (9) of the protective layer (3) located at the bottom of the cavity by exposure to an ion bombardment, in such a way that the implanted portion (9) of the protective layer can be selectively etched with respect to the non-implanted portion (8) of the protective layer;
- (105) forming, in the cavity (7), a second functionalisation layer (10) made of a second material having a second chemical affinity with respect to the block copolymer, the second functionalisation layer (10) comprising a first portion (11) arranged on the protective layer (3) at the bottom (6) of the cavity and a second portion (12) arranged on the side walls (5) of the cavity; and
- (106) etching the implanted portion (9) of the protective layer and the first portion (11) of the second functionalisation layer (10) selectively with respect to the non-implanted portion (8) of the protective layer (3), the second portion (12) of the second functionalisation layer (10) and the first functionalisation layer (2), so as to expose a portion (13) of the first functionalisation layer located at the bottom of the cavity.

2. Method according to the preceding claim, wherein the step (103) of forming the guide pattern (4) comprises the following sub-steps:
- depositing at least one base layer on the protective layer;
- etching the base layer by lithography.

3. Method according to claim 2, wherein the base layer is deposited at a temperature below 300°C, and preferably below 250°C.

4. Method according to one of claims 2 or 3, wherein the base layer comprises carbon.

5. Method according to one of the preceding claims, wherein the protective layer (3) is a layer of a dielectric inorganic material comprising silicon.

6. Method according to one of claims 1 to 5, wherein the ion implantation is carried out by exposure to a plasma, the implanted ions comprising hydrogen and/or helium.

7. Method according to one of claims 1 to 5, wherein the ion implantation is carried out by exposure to an ion beam, the implanted ions comprising one of the following species: Ar, H, He, N₂.

8. Method according to one of claims 1 to 7, wherein the selective etching is a wet etching carried out using a hydrofluoric acid-based or phosphoric acid-based etching solution.

9. Method according to one of claims 1 to 7, wherein the selective etching is a dry etching carried out using a remote plasma, the etching step comprising the following sub-steps:
- a first sub-step of forming a salt from a plasma;
- a second sub-step of sublimation of the salt.

10. Method according to claim 9, wherein the salt is formed from a fluorine and hydrogen-based plasma.

11. Method according to one of claims 9 or 10, wherein the salt is sublimated by an annealing.

12. Method according to one of claims 1 to 7, wherein the selective etching is a vapour phase etching.

13. Method according to claim 12, wherein the vapour phase etching comprises a step of injecting hydrofluoric acid in vapour phase diluted in a solvent on the layers to be etched.

14. Method according to claim 12, wherein the vapour phase etching comprises the following sub-steps:
- injecting a gas of hydrofluoric acid into a reaction chamber in which are placed the layers to be etched;
- injecting an inert gas into the reaction chamber.

15. Method according to one of claims 12 to 14, further comprising a pre-annealing step before the vapour etching step.

16. Method according to one of claims 12 to 15, wherein the vapour etching forms non-volatile reaction products, the method further comprising a step of removing the non-volatile reaction products formed during the vapour etching, the step of removing the non-volatile reaction products comprising:
- a step of solubilising said products in an elimination solution, preferably water; and/or
- a step of annealing at a temperature comprised between 100°C and 300°C.

17. Graphoepitaxy method comprising a method for forming a functionalised guide pattern according to one of claims 1 to 16 and a step of depositing a block copolymer in the cavity.

18. Graphoepitaxy method according to the preceding claim, wherein the block copolymer comprises at least two monomer blocks, the first functionalisation layer having an equivalent affinity with all the monomer blocks, the second functionalisation layer having a preferential affinity with one of the monomer blocks.
